**Europäisches Patentamt**

**European Patent Office**

**Office européen des brevets**

(19)

(11) Numéro de publication : **0 433 198 B1**

(12)

# FASCICULE DE BREVET EUROPEEN

(45) Date de publication du fascicule du brevet :
**27.04.94 Bulletin 94/17**

(51) Int. Cl.⁵ : **H04B 1/68,** H04L 27/02, H04N 5/40

(21) Numéro de dépôt : **90460045.9**

(22) Date de dépôt : **07.12.90**

(54) **Système de transmission à modulation d'amplitude à porteuse supprimée, conservant la polarité du signal transmis.**

(30) Priorité : **11.12.89 FR 8916528**

(43) Date de publication de la demande :
**19.06.91 Bulletin 91/25**

(45) Mention de la délivrance du brevet :
**27.04.94 Bulletin 94/17**

(84) Etats contractants désignés :
**DE GB NL**

(56) Documents cités :
**EP-A- 0 143 469**
**BE-A- 766 847**
**US-A- 3 984 778**

(73) Titulaire : **FRANCE TELECOM**
**6, Place d'Alleray**
**F-75015 Paris (FR)**
Titulaire : **TELEDIFFUSION DE FRANCE S.A.**
**21-27, rue Barbès**
**F-92542 Montrouge Cédex (FR)**

(72) Inventeur : **Lanoiselée, Marc**
**7 rue Bertrand**
**F-35235 Thorigne-Fouillard (FR)**

(74) Mandataire : **Corlau, Vincent**
**c/o Cabinet Patrice Vidon, Immeuble Germanium, 80 avenue des Buttes de Coesmes**
**F-35700 Rennes (FR)**

EP 0 433 198 B1

## Description

Le domaine de l'invention est celui de la transmission de signaux de tous types, analogiques et/ou numériques. Plus précisément, l'invention concerne des systèmes de transmission à modulation d'amplitude exigeant de bonnes performances vis à vis du bruit induit par le canal de transmission.

L'invention s'applique notamment, mais non exclusivement, à la transmission de signaux de télévision, quels qu'en soient leur nature et leur codage, sur tous types de supports, tels que réseaux cablés, antennes collectives, diffusion hertzienne... L'invention peut également s'appliquer aux signaux sonores et aux signaux de données, en particulier lorsqu'un bon niveau de qualité de transmission est requis.

Le principe de base de la modulation d'amplitude est la multiplication (au sens du traitement du signal) du signal à transmettre, ou signal primaire, par un signal porteur, par exemple sinusoïdal, ayant une fréquence au moins deux fois supérieure à la fréquence maximale du signal primaire. La résultante de la multiplication, ou signal modulé, est reçue par le démodulateur.

La démodulation consiste en une seconde multiplication par le signal porteur du signal émis suivi d'un filtrage de type passe-bas permettant de récupérer le signal utile.

Pour cette seconde multiplication, la récupération du signal porteur, au démodulateur, peut se faire de façon quasi-synchrone, par filtrage et limitation du signal reçu. Cependant, cette méthode génère des distorsions après filtrage. Pour s'affranchir de ces défauts, il est possible de démoduler de façon synchrone, la fréquence porteuse étant récupérée par une boucle à asservissement de phase.

Dans le cas des signaux de télévision, et plus généralement de tous les signaux dont il est nécessaire de connaître la polarité, le taux de modulation ne dépasse pas 100%. Cela signifie que la déviation d'amplitude du signal primaire n'excède pas la moitié de l'amplitude du signal haute fréquence obtenu après modulation. Dans le cas contraire, il n'est plus possible d'asservir à la réception une boucle à verrouillage de phase pour récupérer la fréquence porteuse. Il en résulte que le potentiel de cette modulation est, en terme de bruit, sous-utilisé. En effet, plus le taux de modulation est important, meilleures sont les performances de la modulation.

De façon connue, la modulation d'amplitude à porteuse supprimée (MAPS) correspond au cas limite de la modulation à taux de modulation supérieur à 100%, dans lequel l'amplitude maximale du signal primaire égale l'amplitude du signal obtenu après modulation.

Le signal modulé présente alors des sauts de phase entre 0 et 180° directement liés aux passages par 0 du signal primaire. Le fait qu'il y ait autant de passage à 0° qu'à 180° entraine, dans le domaine fréquentiel, la disparition de la fréquence porteuse. Il n'est donc plus possible de réaliser la démodulation synchrone du signal de façon classique. On utilise alors une boucle d'asservissement de phase particulière, dite boucle de Costa, qui réalise les produits du signal reçu par le signal porteur reconstitué en phase et en quadrature. Les produits obtenus sont appliqués en entrée du comparateur de phase d'une boucle à asservissement de phase classique.

La périodicité du comparateur de la boucle d'asservissement de Costa est de périodicité $\pi$, alors qu'elle est de $2\pi$ dans le cas d'un démodulateur classique. Cela entraine l'impossibilité de déterminer la polarité du signal reçu. La non-reconnaissance de la polarité du signal présente peu d'inconvénients dans le cas de signaux sonores, et plus généralement lorsque le signal ne comporte pas de basses fréquences, mais rend non-interprétables certains signaux, et notamment les signaux de télévision.

En résumé, bien que la MAPS présente un gain (de 6dB environ) en performance vis à vis du bruit et des brouilleurs par rapport à la modulation d'amplitude simple, et ne nécessite qu'un faible surcroît de puissance, la perte de la polarité du signal utile en limite les applications.

On connaît d'autre part une autre technique de modulation d'amplitude, la modulation d'amplitude à bande latérale résiduelle (MABLR).

La modulation d'amplitude, qu'elle soit classique ou à porteuse supprimée, présente l'inconvénient supplémentaire d'entrainer une duplication du spectre de fréquences utile, donc un doublement de l'encombrement spectral. En effet, pour un spectre utile compris entre 0 et $f_c$, et pour une fréquence porteuse $f_p$, le spectre transmis sera compris entre les fréquences $f_p-f_c$ et $f_p+f_c$. Ce spectre comprend deux bandes latérales, de part et d'autre de $f_c$, contenant les mêmes informations.

La modulation d'amplitude à bande latérale résiduelle permet de réduire cet encombrement spectral en éliminant partiellement l'une des deux bandes latérales, de telle façon que la restitution correcte du signal reste possible. Cela peut être obtenu par filtrage à flanc de Nyquist. La bande latérale inférieure par exemple est alors partiellement éliminée. Il s'agit dans ce cas d'une transmission infradyne, la fréquence de modulation $f_p$ étant inférieure aux fréquences du spectre transmis.

La MABLR présente l'avantage de diminuer l'encombrement spectral, en éliminant les redondances. Elle est largement utilisée pour la transmission de signaux de télévision. Cependant, ses performances vis à vis du bruit sont limitées de même façon que pour la modulation d'amplitude classique en regard de celles de la

2

MAPS.

Le document BE-A-766 847 divulgue un système de transmission d'un signal utile (mc) numérique, qui comprend, à l'émission, des moyens de modulation d'amplitude à porteuse supprimée dudit signal utile, et des moyens de modulation d'amplitude en quadrature de phase avec ledit signal utile modulé d'un signal de service (α) et, à la réception, des moyens d'analyse dudit signal de service démodulé produisant une information sur la phase de la porteuse.

L'invention a notamment pour objectif de pallier ces inconvénients des techniques de modulation d'amplitude connues.

Plus, précisément, l'objectif de l'invention est de fournir un système de modulation d'amplitude présentant des caractéristiques vis à vis du bruit et des brouilleurs identiques à celles de la modulation à porteuse supprimée (MAPS), tout en conservant la polarité du signal transmis.

L'invention a notamment pour objectif de fournir un tel système, permettant la transmission de signaux de tout type, numérique et/ou analogique, et en particulier de signaux de télévision, pour lesquels la conservation de la polarité est nécessaire. L'invention peut par exemple être utilisée pour la transmission de signaux de type MAC (Multiplexed Analog Components (Composantes Analogiques Multiplexées))

Un objectif complémentaire de l'invention est, dans un mode de réalisation particulier, de fournir un tel système de modulation à faible encombrement spectral, semblable à celui de la modulation à bande latérale résiduelle (MABLR).

Un autre objectif de l'invention est de fournir un tel système de modulation, permettant la transmission d'informations complémentaires au signal utile.

L'invention a également pour objectif de fournir des récepteurs assurant la réception tant de signaux transmis en modulation d'amplitude simple, à bande latérale résiduelle, ou à porteuse supprimée, que de signaux transmis selon la technique de modulation d'amplitude de l'invention.

Un objectif complémentaire de l'invention est d'utiliser le principe de transmission de l'invention pour permettre un accrochage rapide et sûr de la boucle d'asservissement de phase des récepteurs de tels systèmes.

Ces objectifs, ainsi que d'autres qui apparaîtront par la suite, sont atteints à l'aide d'un système de transmission d'un signal utile analogique et/ou numérique, comprenant, à l'émission, des moyens de modulation d'amplitude à porteuse supprimée dudit signal utile, et des moyens de modulation d'amplitude en quadrature de phase avec ledit signal utile modulé d'un signal de service, et, à la réception, des moyens d'analyse dudit signal de service démodulé produisant une information sur la polarité du signal utile démodulé.

Ainsi, un signal utile quelconque peut être transmis en MAPS, avec les avantages que cela procure, notamment vis à vis du bruit, sans problème vis à vis de sa polarité. En effet, le signal de service transmis conjointement est tel qu'il permet de déterminer, par analyse, son signe, et donc celui identique du signal utile.

Le signe du signal de service peut par exemple être déterminé par analyse de sa dissymétrie, si celle-ci est connue du récepteur, ou par démodulation classique, s'il est modulé avec un taux de modulation inférieure à 100%.

Avantageusement, lesdits moyens de modulation dudit signal utile et/ou dudit signal de service comprennent des moyens de modulation à bande latérale résiduelle.

L'invention conjugue de cette façon les avantages particuliers de la MAPS et de la MABLR. on notera que la MABLR est notamment intéressante pour le signal utile, qui présente une bande passante plus large que le signal de service.

Dans un mode de réalisation particulier de l'invention, ledit signal de service est un signal continu.

Dans ce cas, un simple seuillage sur le signal de service démodulé permet de déterminer son signe.

Dans un autre mode de réalisation avantageux, ledit signal de service est un signal contenant des informations complémentaires au signal utile.

Dans ce cas, ledit signal de service est préférentiellement un signal basse fréquence, dont la fréquence maximale est déterminée en fonction du niveau de brouillage tolérable entre la voie utile et la voie de service.

Ledit signal de service peut également être, de façon avantageuse, un signal corrélé avec le signal utile, de façon que lesdites informations sont transmises sélectivement pendant des intervalles de temps, correspondant à des instants de transition dudit signal utile.

Il peut notamment être un signal de synchronisation.

Avantageusement, ledit signal utile est un signal de télévision, notamment du type constitué d'un multiplexage temporel de signaux analogiques et/ou numériques.

L'invention peut ainsi s'appliquer à la transmission des signaux aux normes MAC, et plus généralement à tous les signaux de télévision, dont les signaux de télévision haute définition.

Dans un tel système, l'émetteur comprend préférentiellement des moyens d'atténuation dudit signal de service modulé par rapport audit signal utile modulé.

En effet, il est souhaitable que le signal de service, dont l'objectif principal est de lever l'ambiguïté sur la polarité du signal utile reçu, ne perturbe pas ce signal utile.

Le récepteur d'un tel système comprend de façon avantageuse une boucle à asservissement de phase, du type dit boucle de Costa, des moyens de restitution du signal utile démodulé sous forme directe et sous forme inversée, et des moyens de sélection de l'un desdits moyens de restitution, en fonction d'une information produite par des moyens d'analyse dudit signal de service démodulé.

De façon préférentielle, chacune des boucles de contreréaction de la boucle d'asservissement comprend des moyens de filtrage passe-bande.

Dans un mode de réalisation préférentiel du récepteur de l'invention, ladite boucle d'asservissement de phase comprend un filtre de boucle comprenant un filtre intégrateur et un correcteur proportionnel intégral.

Avantageusement, ledit récepteur comprend des moyens d'accrochage rapide de ladite boucle, par analyse de ladite voie de service.

De façon avantageuse, lesdits moyens d'accrochage rapide comprennent des moyens de commutation de constante de boucle et un oscillateur vobulant l'oscillateur contrôlé en tension de ladite boucle d'asservissement de phase.

D'autres caractéristiques et avantages de l'invention apparaîtront à la lecture de la descritpion suivante d'un mode de réalisation préférentiel de l'invention, donné à titre illustratif et non limitatif, et des dessins annexés, dans lesquels :

- la figure 1 est le diagramme fonctionnel d'un mode de réalisation particulier d'un modulateur selon l'invention ;
- la figure 2 est le diagramme fonctionnel d'un mode de réalisation particulier d'un démodulateur selon l'invention ;
- la figure 3 illustre la réponse en fréquence d'un filtre à flanc de Nyquist ;
- la figure 4 est un schéma présentant l'effet d'un filtrage à flanc de Nyquist sur un spectre de fréquence ;
- la figure 5 présente un exemple de signaux transmis, dans le cas d'un signal utile de type D2-MAC et d'un signal de service portant une synchronisation.

Le système de transmission de l'invention permet la transmission d'un signal en modulation d'amplitude à porteuse supprimée, tout en conservant sa polarité. Ainsi, il est possible de transmettre dans de bonnes conditions de résistance au bruit des signaux, sans en perdre le signe.

Pour cela, on transmet, en quadrature de phase avec le signal utile, un signal de service. L'analyse à la réception de ce second signal permet de déterminer son signe, et donc celui du signal utile, qui est identique.

De façon à réduire l'encombrement spectral, la modulation d'amplitude à porteuse supprimée peut être à bande latérale résiduelle, pour le signal utile, et éventuellement pour le signal de service.

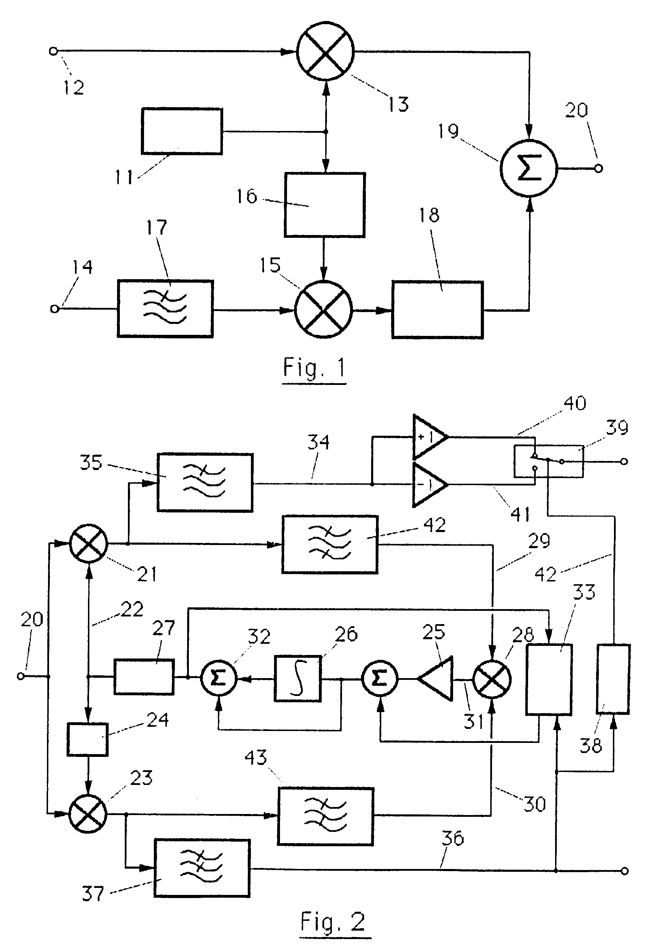

La figure 1 présente le diagramme fonctionnel d'un modulateur selon l'invention. Ce modulateur comprend des moyens d'amplitude de deux voies en quadrature de phase.

Un oscillateur local 11 à la fréquence $f_p = w_p/2\pi$ génère une porteuse $u_p \cos w_p t$. Cette porteuse module le signal utile 12 $u_1(t)$, par l'intermédiaire d'un multiplicateur 13. La modulation est du type dit à porteuse supprimée.

Le signal de service 14 $u_o(t)$, est modulé, en quadrature de phase avec le signal utile, par la porteuse $u_p \sin w_p t$, à l'aide d'un second multiplicateur 15. La porteuse $u_p \sin w_p t$ est obtenue par un déphasage 16 de $-\pi/2$ du signal issu de l'oscillateur local 11. Dans le cas où le signal $u_o(t)$ 14 n'est pas corrélé avec le signal utile 12, il est préalablement filtré par un filtre passe-bas 17, pour limiter le brouillage intervoie.

La voie de service est ensuite soumise à une atténuation de niveau 18, de façon qu'elle pertube le moins possible le signal utile. Le but prioritaire de ce signal de service étant de déterminer sa polarité à la réception, sa qualité n'a que peu d'importance, par rapport à celle du signal utile.

Les deux signaux modulés en quadrature de phase sont additionnés, par un sommateur 19. Le signal résultant 20 est émis.

La figure 2 est le diagramme fonctionnel du démodulateur selon l'invention. La porteuse de démodulation est reconstitué par l'intermédiaire d'une boucle à asservissement de phase adapté au signal MAPS, dite boucle de Costa, décrite en préambule.

Dans ce démodulateur, un multiplicateur 21 réalise sur la voie utile la démodulation du signal reçu 20, par le porteur reconstitué en phase 22. Un second multiplicateur 23 effectue sur la voie de service la démodulation du signal de service, par le même porteur 22 déphasé en quadrature par un déphaseur $\pi/2$ 24.

Le porteur reconstitué 22 est généré par la boucle d'asservissement de phase, comprenant, de façon classique, un amplificateur 25, un filtre de boucle 26, un oscillateur local 27 et un comparateur de phase 28.

Le comparateur de phase 28 est constitué d'un multiplicateur, qui effectue le produit entre les deux signaux démodulés 29 et 30. Le signal d'erreur 31 obtenu est ensuite filtré, par le filtre de boucle passe-bas 26, afin de le moyenner. Le signal d'erreur 31 pilote ensuite l'oscillateur contrôlé en tension 27 qui génère le porteur 22.

Le filtre de boucle 26 peut être de tout type. Les performances les meilleures sont obtenues par des moyens de filtrage comprenant un intégrateur 26 et un correcteur proportionnel intégral 32. Dans ce cas, le correcteur proportionnel intégral 32 assure la stabilité du système, la combinaison de deux intégrateurs (intégrateur 26 et oscillateur 27) posant en effet des problèmes. Le filtre intégrateur 26 est de préférence à grande constante de temps.

La boucle de Costa est de préférence une boucle du second ordre. Toutefois, une telle boucle se caractérise par des temps d'acquisition en fréquence et en phase très long, nécessitant un dispositif 33 facilitant l'accrochage. Ce dispositif peut être constitué d'un oscillateur, inhibé lorsque le taux de contre réaction devient suffisant, ou d'un système de commutation à différentes valeurs de la constante de temps de la boucle.

Les propriétés du signal de service permettent d'autre part de disposer d'un dispositif efficace d'accrochage de la boucle. Il est constitué d'un système de commutation de constante de boucle et d'un oscillateur vobulant l'oscillateur contrôlé en tension sur sa plage de fréquence. Il est important que cette fonction soit mise en service uniquement aux moments appropriés. Le signal de service fournit de façon stable et fiable l'état de verrouillage de la boucle. A titre d'exemple, lorsque ce signal de service est un niveau continu, ce niveau n'est effectivement observé que lorsque l'oscillateur est accordé avec le signal d'entrée. La référence obtenue est indépendante du signal utile. Ce dispositif est donc insensible aux éventuelles suppressions momentanées ou périodiques survenant sur le signal utile, et aux faux accrochages parfois observés sur des signaux échantillonnés.

Un autre avantage de ce dispositif est de permettre au démodulateur de se verrouiller rapidement lors de commutation sur différentes sources non-synchrones, constituées par exemple par les voies d'un multiplex temporel.

La périodicité de ce comparateur étant moitié moindre de celle d'un démodulateur d'amplitude classique, la voie utile restitue, à $\pi$ près, donc au signe près, le signal utile 34, après filtrage passe-bas 35. Dans le cas d'un signal vidéo, le filtre 35 peut avoir par exemple, une fréquence de coupure de 8 MHz.

La voie de service fournit le signal de service 36, après filtrage 37. Ce filtrage passe-bas 37 a par exemple une fréquence de coupure de 1 kHz. La nature de ce signal de service 36, s'il a été modulé avec un taux de modulation inférieur à 100%, ou, s'il présente une dissymétrie connue du récepteur, permet de lever l'indétermination du signe de la démodulation par boucle de Costa.

Un module 38 de détermination du signe pilote un commutateur 39, qui permet de sélectionner la sortie filtrée directe 40 ou inversée 41 de la voie utile.

Ce module 38 produit une information 42 sur la polarité du signal reçu. Si le signal de service a été modulé avec un taux de modulation inférieur à 100%, le module 38 réalise de façon classique sa démodulation, puis compare le signal obtenu avec le signal démodulé par la boucle de Costa. S'ils sont identiques, la sortie directe 40 est sélectionnée, par action sur le commutateur 39. Dans le cas contraire, la sortie inversée 41 est choisie.

Le module 38 peut également effectuer une analyse directe du signal de service reçu. Par exemple, dans le cas d'un signal de service continu, le module 38 réalise un simple seuillage du signal reçu, permettant de déterminer si celui-ci est inversé ou non. Le module 38 peut ainsi être un circuit comparateur, le signal de commutation 42 étant produit par la tension continue récupérée sur la voie de service si elle est d'amplitude suffisante.

Le signal de service peut être aussi généré à partir d'une implusion de synchronisation coïncidant avec une ligne particulière du signal (ligne test). A la réception, un comparateur à hytérésis suffit pour réaliser le module 38.

Dans le cas d'un signal de service corrélé au signal utile présentant un rapport cyclique différent de 1/2, de façon que ce signal ne soit pas symétrique, le module 38 de détermination du signe peut être réalisé avec deux détecteurs de crêtes présentant des constantes de temps assez faibles en regard de la période du signal. L'indication de la polarité 42 est alors fournie par un comparateur à hystérésis.

Le système de transmission selon l'invention permet également de transmettre des signaux en modulation d'amplitude à bande latérale résiduelle. Ainsi, on cumule l'avantage de faible encombrement spectral de la MABLR avec celui de résistance au bruit de la MAPS.

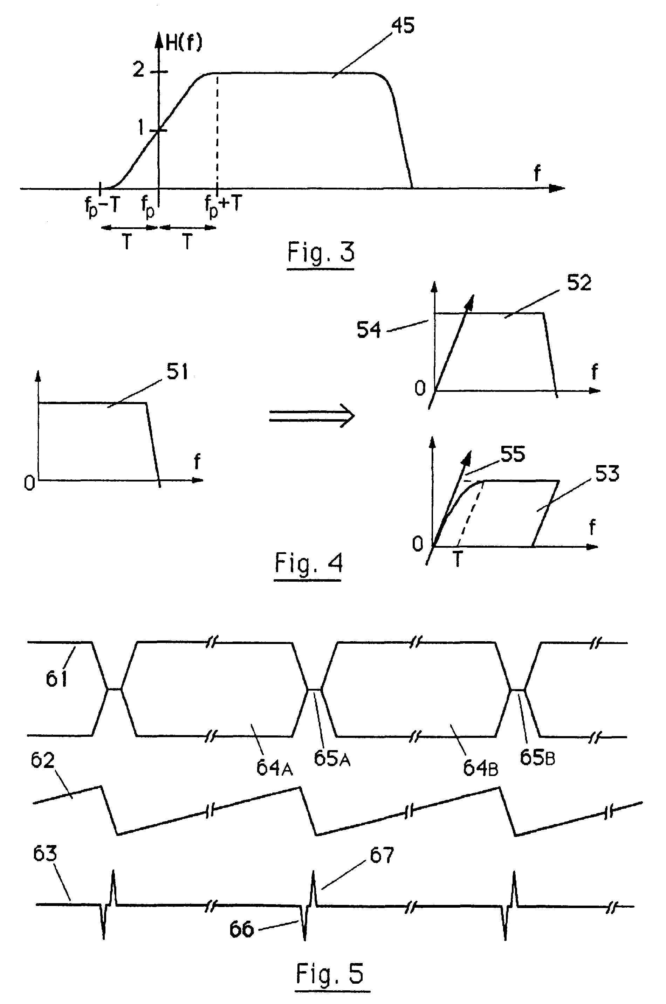

La modulation à bande latérale résiduelle est obtenue par filtrage du signal modulé par un filtre à flanc de Nyquist. La figure 3 représente la réponse en fréquence 45 d'un tel filtre. La bande latérale du spectre inférieure à la fréquence porteuse est en grande partie éliminée. La fonction de transfert du filtre H(f) est définie par :

$$H(f) = 0 \text{ pour } f < f_p - T$$
$$H(f) = 1 + \sin(\pi(f - f_p)/2T) \text{ pour } f_p - T \leqq f \leqq f_p + T$$
$$H(f) = 2 \text{ pour } f > f_p + T$$

où :

$f_p$ :      fréquence porteuse,

5

T : talon du filtre.

Ce filtre à flanc de Nyquist peut être placé soit à l'émission, soit à la réception du signal. S'il est placé à l'émission, il est associé à la réception à un filtre de canal, transparent pour le filtre de Nyquist. Dans le cas où il est placé à la réception du signal, il est associé à un filtre de bande à l'émission.

La figure 4 montre l'effet d'un filtrage à flanc de Nyquist sur un spectre 51 de fréquences comprises entre 0 et f. Le signal obtenu en sortie du filtre se comporte comme la somme de deux signaux 52 et 53 résultant de la modulation de deux porteurs en quadrature par deux signaux primaires identiques pour les fréquences supérieures à $f_p + T$ également en quadrature de phase. Ainsi, le spectre de fréquence à transmettre est recopié entièrement sur la voie en phase 54, et en partie sur la voie en quadrature 55, les fréquences basses, inférieures au talon T du filtre à flanc de Nyquist, étant atténuées.

La présence de ces deux signaux en quadrature rend obligatoire, pour que le signal utile puisse être récupéré sans distorsion, une démodulation synchrone.

En MABLR classique, la composante obtenue sur la voie démodulée en quadrature présente une valeur moyenne nulle. Le filtrage à flanc de Nyquist ne perturbe pas le fonctionnement de la boucle d'asservissement de phase de démodulation dans ce cas. Cependant, le filtre passe-bas de boucle est avantageusement le plus raide possible.

Dans le système de transmission selon l'invention, le signal de service, transmis en quadrature de phase avec le signal utile, se superpose au signal en quadrature produit par le filtre à flanc de Nyquist.

D'autre part, l'influence de ce filtre se traduit par une pondération en passe-bas du gain de la boucle de Costa, qui devient nul pour les fréquences du signal utile supérieures au talon T. Afin de pallier ces inconvénients, les filtres 42 et 43 (figure 2) de contre-réaction de la boucle de Costa, classiquement de type passe-bas, sont avantageusement remplacés par des filtres passe-bande de fréquence de coupure basse supérieure à la fréquence maximale du signal de service.

Ce filtre entraîne également la recopie du spectre du signal de service sur le signal utile. Il est donc nécessaire, une seconde fois, que l'occupation spectrale du signal de service soit limitée aux basses fréquences. Dans le cas contraire, le signal utile sera fortement perturbé par le brouillage intervoies, et le taux de contre-réaction de la bande de Costa insuffisant.

Ce signal de service peut donc être soit un signal continu, soit un signal basse fréquence, contenant des informations complémentaires au signal utile. Tant que les fréquences restent inférieures au talon du filtre à flanc de Nyquist, les problèmes de brouillage intervoie sont négligeables.

Il est cependant possible de transmettre un signal de fréquence supérieure, si ce signal est corrélé avec le signal utile. Ainsi, on peut transmettre sur la voie de service lorsqu'il n'y a pas d'information utile sur la voie principale. Dans le cas des signaux de type X-MAC (D-MAC, D2-MAC, HD-MAC,...), il est par exemple possible de transmettre une salve numérique brève pendant les instants de transition.

Une autre possibilité est de transmettre sur la voie de service un signal de synchronisation analogique. La figure 5 présente les deux voies transmises dans le cas d'un signal X-MAC 61 et d'un signal de synchronisation 62. Un tel signal est transmis par lignes $64_A$ et $64_B$, séparées par des instants de transition $65_A$, $65_B$, ou instants de clamp. Un tel signal de synchronisation analogique 62 présente l'avantage d'être beaucoup plus robuste qu'une synchronisation numérique. Les fronts de ce signal 62 correspondent à des instants de transition du signal principal ne faisant l'objet d'aucune prise en compte. Le signal 63 est le signal dupliqué sur la voie utile. Les pics 66, 67 n'intervenant qu'aux instants de transition, le signal utile 61 n'est pas perturbé. De façon qu'il soit possible de déterminer la polarité du signal de service 62, il est nécessaire que celui-ci soit dissymétrique, dans le cas où il est modulé en MAPS.

Dans le cas d'un signal D2-MAC, le dispositif de l'invention permet de transmettre le signal avec un gain sur le rapport signal sur bruit démodulé supérieur à 6 dB par rapport à une modulation d'amplitude à 90%, et avec un encombrement spectral réduit.

Il apparaît ainsi que le système de l'invention est très avantageux pour la transmission de signaux de télévision analogiques et/ou numériques, par exemple du type D2-MAC ou HD-MAC. Toutefois, l'invention ne se limite pas à un système de télévision particulier, ni même aux signaux vidéo. Tout type de signal peut être transmis par ce système, avec une bonne qualité de transmission, un faible encombrement spectral et un accrochage en boucle rapide et solide.

Par ailleurs, il est à noter que les émetteurs et récepteurs de l'invention permettent également la transmission et la réception des signaux modulés en MAPS ou en MABLR classiques.

**Revendications**

1. Système de transmission d'un signal utile (12) analogique et/ou numérique, qui comprend, à l'émission, des moyens (11, 13) de modulation d'amplitude à porteuse supprimée dudit signal utile (12), et des moyens (11, 15, 16) de modulation d'amplitude en quadrature de phase avec ledit signal utile modulé d'un signal de service (14), caractérisé en ce qu'il comprend à la réception, des moyens (38) d'analyse dudit signal de service démodulé (36) produisant une information (42) sur la polarité du signal utile démodulé (34).

2. Système selon la revendication 1, caractérisé en ce que lesdits moyens de modulation dudit signal utile et/ou dudit signal de service comprennent des moyens (45) de modulation à bande latérale résiduelle.

3. Système selon l'une quelconque des revendications 1 ou 2, caractérisé en ce que ledit signal de service (14) appartient au groupe comprenant les signaux suivants :
   - un signal continu ;
   - un signal basse fréquence, contenant des informations complémentaires au signal utile (12) et dont la fréquence maximale est déterminée en fonction du niveau de brouillage tolérable entre la voie utile et la voie de service ;
   - un signal corrélé avec le signal utile (12), notamment un signal de synchronisation (62), contenant des informations complémentaires au signal utile (12) transmises sélectivement pendant des intervalles de temps (65A, 65B) correspondant à des instants de transition dudit signal utile (12).

4. Système selon l'une quelconque des revendications 1 à 3, caractérisé en ce que ledit signal utile (12) est un signal de télévision (61), notamment du type constitué d'un multiplexage temporel de signaux analogiques et/ou numériques.

5. Emetteur d'un système selon l'une quelconque des revendications 1 à 4, caractérisé en ce qu'il comprend des moyens d'atténuation (18) dudit signal de service modulé par rapport audit signal utile modulé.

6. Récepteur d'un système selon l'une quelconque des revendications 1 à 4, caractérisé en ce qu'il comprend une boucle à asservissement de phase, du type dit boucle de Costa, des moyens de restitution du signal utile démodulé (34) sous forme directe (40) et sous forme inversée (41), et des moyens (39) de sélection de l'un desdits moyens de restitution (40, 41) en fonction d'une information (42) produite par des moyens (38) d'analyse dudit signal de service démodulé (36).

7. Récepteur selon la revendication 6, caractérisé en ce que chacune des boucles de contreréaction de ladite boucle à asservissement de phase comprend des moyens (42, 43) de filtrage passe-bande.

8. Récepteur selon l'une quelconque des revendications 6 et 7, caractérisé en ce que ladite boucle d'asservissement de phase comprend un filtre de boucle comprenant un filtre intégrateur (26) et un correcteur proportionnel intégral (32).

9. Récepteur selon l'une quelconque des revendications 6 à 8, caractérisé en ce qu'il comprend des moyens (33) d'accrochage rapide de ladite boucle d'asservissement de phase, par analyse dudit signal de service (36).

10. Récepteur selon la revendication 9, caractérisé en ce que lesdits moyens (33) d'accrochage rapide comprennent des moyens de commutation de constante de boucle et un oscillateur vobulant l'oscillateur contrôlé en tension (27) de ladite boucle d'asservissement de phase.

**Patentansprüche**

1. Übertragungssystem für ein analoges und/oder digitales Nutzsignal, welches beim Senden über Mittel (11, 13) zur trägerunterdrückenden Amplitudenmodulation des besagten Nutzsignals (12) sowie über Mittel (11, 15, 16) zur 90° phasenverschobenen Amplitudenmodulation bezüglich des besagten, mit einem Dienstsignal (14) modulierten Nutzsignal, verfügt, dadurch gekennzeichnet, daß es beim Empfang über Mittel (38) zur Analyse des besagten demodulierten Dienstsignals (36) verfügt, die eine Information (42) über die Polarität des demodulierten Nutzsignals (34) erzeugen.

2. System gemäß Anspruch 1, dadurch gekennzeichnet, daß die besagten Modulationsmittel des besagten Nutzsignals und/oder des besagten Dienstsignals über Restseitenbandmodulationsmittel (45) verfügen.

3. System gemäß irgendeinem der Ansprüche 1 oder 2, dadurch gekennzeichnet, daß das besagte Dienstsignal (14) zur Gruppe gehört, welche die folgenden Signale umfaßt:
- ein kontinuierliches Signal;
- ein Niederfrequenzsignal, welches komplementäre Informationen zum Nutzsignal (12) enthält und dessen Höchstfrequenz als Funktion des annehmbaren Interferenzpegels zwischen dem Nutzkanal und dem Dienstkanal festgestellt wird:
- ein mit dem Nutzsignal (12) korreliertes Signal, insbesondere ein Synchronisierungssignal (62), das komplementäre Informationen zum Nutzsignal (12) enthält, welche selektiv während Zeitintervalle (65A, 65B) gesendet werden, die Übergangsmomente des besagten Nutzsignals (12) entsprechen.

4. System gemäß irgendeinem der Ansprüche 1 bis 3, dadurch gekennzeichnet, daß es sich beim besagten Nutzsignal (12) um ein Fernsehsignal (61) handelt, insbesondere von der Art, die aus einem Zeitmultiplexieren analoger und/oder digitaler Signale besteht.

5. Sender eines Systems gemäß irgendeinem der Ansprüche 1 bis 4, dadurch gekennzeichnet, daß er Dämpfungsmittel (18) zum Dämpfen des besagten modulierten Dienstsignals im Verhältnis zum besagten modulierten Nutzsignal enthält.

6. Empfänger eines Systems gemäß irgendeinem der Ansprüche 1 bis 4, dadurch gekennzeichnet, daß er über eine Phasenangleichungsschleife der Costa-Schleife genannten Art verfügt sowie über Wiederherstellungsmittel des demodulierten Nutzsignals (12) in direkter (40) und umgekehrter (41) Form und über Auswahlmittel (39) zum Auswählen eines der besagten Wiederherstellungsmittel (40, 41) als Funktion einer Information (42), die durch Analysemittel (38) des besagten demodulierten Dienstsignals (36) erzeugt wird.

7. Empfänger gemäß Anspruch 6, dadurch gekennzeichnet, daß jede Rückkopplungsschleife der besagten Phasenangleichungsschleife über Bandpaßfiltermittel (42, 43) verfügt.

8. Empfänger gemäß irgendeinem der Ansprüche 6 und 7, dadurch gekennzeichnet, daß die besagte Phasenangleichungsschleife über ein Schleifenfilter verfügt, welches ein Integratorfilter (26) und einen Proportional-Integralkorrektor (32) enthält.

9. Empfänger gemäß irgendeinem der Ansprüche 6 bis 8, dadurch gekennzeichnet, daß er über Mittel (33) zum schnellen Einrasten in die besagte Phasenangleichungsschleife durch Analyse des besagten Dienstsignals(36) verfügt.

10. Empfänger gemäß Anspruch 9, dadurch gekennzeichnet, daß die besagten schnellen Einrastmittel (33) Umschaltmittel der Schleifenkonstante enthalten sowie einen Schwingkreis, der den spannungsgesteuerten Schwingkreis (27) der besagten Phasenangleichungsschleife wobbelt.

**Claims**

1. System for the transmission of an analog and/or digital useful signal (12) which comprises, at transmission, means (11, 13) for the suppressed carrier amplitude modulation of the said useful signal (12) and means (11, 15, 16) for the amplitude modulation, in phase quadrature with the said modulated useful signal, of a service signal (14), characterized in that it comprises at reception, means (38) for the analysis of the said demodulated service signal (36) producing a piece of information (42) on the polarity of the demodulated useful signal (34).

2. System according to Claim 1, characterized in that the said means for modulation of the said useful signal and/or the said service signal comprise vestigial sideband modulation means (45).

3. System according to either of Claims 1 or 2, characterized in that the said service signal (14) belongs to the group comprising the following signals:
- a continuous signal;
- a low-frequency signal, containing information complementary to the useful signal (12) and having its maximum frequency determined as a function of the level of interference tolerable between the useful channel and the service channel;

- a signal correlated with the useful signal (12), notably a synchronization signal (62), containing information complementary to the useful signal (12) transmitted selectively during time intervals (65A, 65B) corresponding to instants of transition of the said useful signal (12).

4. System according to any one of Claims 1 to 3, characterized in that the said useful signal (12) is a television signal (61), notably of the type constituted by a time-division multiplexing of analog and/or digital signals.

5. Transmitter of a system according to any one of Claims 1 to 4, characterized in that it includes means (18) for the attenuation of the said modulated service signal with respect to the said modulated useful signal.

6. Receiver of a system according to any one of Claims 1 to 4, characterized in that it includes a phase control loop, of the type called a Costas loop, means for restoring the demodulated useful signal (34) in direct form (40) and in inverted form (41) and means (39) for selecting one of the said restoring means (40, 41) as a function of a piece of information (42) produced by means (38) for analysing the said demodulated service signal (36).

7. Receiver according to Claim 6, characterized in that each of the reverse feedback loops of the said phase control loop includes bandpass filtering means (42, 43).

8. Receiver according to either of Claims 6 and 7, characterized in that the said phase control loop has a loop filter including an integrator filter (26) and a proportional integral corrector (32).

9. Receiver according to any one of Claims 6 to 8, characterized in that it includes means (33) for fast locking into the said phase control loop, by analysis of the said service signal (36).

10. Receiver according to Claim 9, characterized in that the said fast locking-in means (33) include loop constant switchover means and an oscillator wobbulating the voltage controlled oscillator (27) of the said phase control loop.

Fig. 1

Fig. 2

Fig. 3

Fig. 4

Fig. 5

11